# EUROPÄISCHE PATENTSCHRIFT

(11) **EP 2 197 781 B1**
(45) Veröffentlichungstag und Bekanntmachung des Hinweises auf die Patenterteilung: **06.04.2011**
(21) Anmeldenummer: 08803521.7
(22) Anmeldetag: 02.09.2008
(51) Int. Cl.: B81C 1/00

(54) **VERBUND AUS MINDESTENS ZWEI HALBLEITERSUBSTRATEN SOWIE HERSTELLUNGSVERFAHREN**
COMPOSITE COMPRISING AT LEAST TWO SEMICONDUCTOR SUBSTRATES AND PRODUCTION METHOD
COMPOSITE CONSTITUÉ D'AU MOINS DEUX SUBSTRATS SEMI-CONDUCTEURS, ET PROCÉDÉ DE FABRICATION

(30) Priorität: 10.10.2007 DE 102007048604
(43) Veröffentlichungstag der Anmeldung: 23.06.2010
(73) Patentinhaber: Robert Bosch GmbH, 70442 Stuttgart (DE)
(72) Erfinder: FRANKE, Axel, 71254 Ditzingen (DE); TRAUTMANN, Achim, 71229 Leonberg (DE); FEYH, Ando, 71732 Tamm (DE); KNIES, Sonja, 71229 Leonberg (DE)
(86) Internationale Anmeldenummer: PCT/EP2008/061550
(87) Internationale Veröffentlichungsnummer: WO 2009/049958

(56) Entgegenhaltungen:
- WO-A-02/42716
- US-A- 3 461 462
- US-A- 5 693 574

## Beschreibung

### Stand der Technik

Die Erfindung betrifft einen Verbund aus mindestens zwei Halbleitersubstraten gemäß dem Oberbegriff des Anspruchs 1 sowie ein Verfahren zum Herstellen eines Verbundes aus mindestens zwei Halbleitersubstraten gemäß Anspruch 8.

Aus der US 2006/0208326 A1 ist ein Verbund aus einem mindestens ein MEMS-Bauelement aufweisenden Halbleitersubstrat und einem ein CMOS-Bauelement aufweisenden zweiten Halbleitersubstrat bekannt. Dabei besteht eine eutektische Verbindung zwischen einer auf dem ersten Halbleitersubstrat vorgesehenen Germanium-Schicht und einer korrespondierenden, auf dem zweiten Halbleitersubstrat vorgesehenen Aluminium-Schicht. Durch die eutektische Verbindung zwischen der Germanium-Schicht und der Aluminium-Schicht wird eine hohe Bondstärke des Verbundes realisiert. Nachteilig bei dem bekannten Verbund ist jedoch, dass die Germanium-Schicht auf dem MEMS-Halbleitersubstrat bei dessen Herstellung aufwendig geschützt werden muss, da die Germanium-Schicht vor einem notwendigen Trench-Prozess aufgebracht wird, bei dem Germanium im gleichen Maße ätzbar ist wie das Halbleitersubstratmaterial.

Aus der WO 02/42716 A2 sind ein mikromechanischer Drehratensensor und dessen Herstellung bekannt, bei dem ein Sensor durch Aufsetzen eines Gegensubstrats auf ein Basissubstrat verkapselt wird. Zwischen den beiden Substraten ist eine Aluminium-Germaniumverbindung und eine Gold-Germaniumverbindung vorgesehen.

### Offenbarung der Erfindung

### Technische Aufgabe

Der Erfindung liegt daher die Aufgabe zugrunde, einen im Hinblick auf eine einfache Fertigbarkeit optimierten Verbund aus mindestens zwei Halbleitersubstraten vorzuschlagen, von denen mindestens eines ein MEMS-Bauelement trägt. Ferner besteht die Aufgabe darin ein entsprechend optimiertes, d. h. einfaches Herstellungsverfahren für einen derartigen Verbund vorzuschlagen.

### Technische Lösung

Diese Erfindung wird hinsichtlich des Verbundes mit dem Merkmal des Anspruchs 1 und hinsichtlich des Herstellungsverfahrens mit den Merkmalen des Anspruchs 8 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren offenbarten Merkmalen. Zur Vermeidung von Wiederholungen sollen rein vorrichtungsgemäß offenbarte Merkmale auch als verfahrensgemäß offenbart gelten und beanspruchbar sein. Ebenso sollen rein verfahrensgemäß offenbarte Merkmale als vorrichtungsgemäß offenbart gelten und beanspruchbar sein.

Der Erfindung liegt der Gedanke zugrunde, die mindestens eine, Aluminium enthaltende Schicht auf dem ersten, mindestens ein MEMS-Bauelement aufweisenden Halbleitersubstrat und die mindestens eine, Germanium enthaltende Schicht auf dem zweiten Halbleitersubstrat anzuordnen bzw. aufzubringen. Unter einem MEMS-Bauelement im Sinne der Erfindung wird ein Bauelement eines so genannten Micro-Electro-Mechanical Systems verstanden. Insbesondere handelt es sich bei dem MEMS-Bauelement um ein mechanisches Bauelement, beispielsweise um einen Sensor oder ein Sensorteil oder um einen Aktor oder ein Aktorteil. Ein nach dem Konzept der Erfindung ausgebildeter Verbund hat herstellungstechnisch gegenüber dem bekannten Verbund entscheidende Vorteile. So wird die mindestens eine, Aluminium enthaltende Schicht auf dem ersten Halbleitersubstrat während eines Trench- oder Opferschichtprozesses zur Herstellung des Halbleitersubstrates, insbesondere des mindestens einen MEMS-Bauelementes, nicht angegriffen, so dass auf einen aufwendigen Schutz der mindestens einen, Aluminium enthaltenden Schicht, die in einem späteren Verbindungsschritt zur Ausbildung einer eutektischen Verbindung zu der mindestens einen Germanium enthaltenden Schicht dient, verzichtet werden kann. Bevorzugt ist eine Ausführungsform, bei der in mehreren voneinander beabstandeten Regionen auf dem Halbleitersubstrat jeweils mindestens eine Aluminium bzw. Germanium enthaltende Schichten aufgebracht sind.

Durch die Ausbildung einer statisch eutektischen Verbindung zwischen der mindestens einen, Germanium enthaltenden Schicht und der mindestens einen, Aluminium enthaltenden Schicht kann eine hermetische Kapselung von MEMS-Bauelementen realisiert werden.

Besonders bevorzugt ist eine Ausführungsform des Verbundes bei der das zweite Halbleitersubstrat mindestens ein ASIC-Bauelement aufweist. Bei einem ASIC-Bauelement handelt es sich um ein Bauelement einer anwendungsspezifischen integrierten Schaltung, auch Custom-Chip genannt. Unter einem ASIC-Bauelement wird dabei im Rahmen der Weiterbildung ein Bauelement der elektronischen Schaltung oder die elektronische Schaltung als solches verstanden. Beispielsweise handelt es sich bei dem ASIC-Bauelement um einen CMOS-Baustein, also einen complementary metal oxyde semiconductor. Das Vorsehen der mindestens einen, Germanium enthaltenden Schicht auf dem zweiten, mindestens ein ASIC-Bauelement enthaltenden Halbleitersubstrat ist vorteilhaft, da die Germaniumdeposition als letzter Verfahrensschritt bei der Herstellung des zweiten Halbleitersubstrates aufgebracht werden kann, wodurch eine Passivierung der mindestens einen Germanium enthaltenden Schicht unterbleiben kann. Der eutektische Bondvorgang führt zur Ausbildung einer mechanisch stabilen, elektrisch leitfähigen und hermetischen Verbindung von ASIC und MEMS.

Um eine optimale Verbindung der mindestens einen, Aluminium enthaltenden Schicht und der mindestens einen, Germanium enthaltenden Schicht bei dem eutektischen Bondprozess zu erhalten, ist eine Ausführungsform von Vorteil, bei der die Aluminium enthaltende Schicht und/oder die Germanium enthaltende Schicht, insbesondere vor der eutektischen Verbindung, strukturiert, vorzugsweise mikrostrukturiert, wird. Dabei ist es denkbar die bereits aufgebrachten Schichten zu strukturieren und/oder zumindest eine der Schichten bereits strukturiert aufzubringen.

In Weiterbildung der Erfindung ist mit Vorteil vorgesehen, dass die Aluminium enthaltende Schicht aus Aluminium und/oder AlSiCu und/oder aus AlSi und/oder AlCu gebildet ist.

Zum Herstellen einer ausreichend stabilen eutektischen Verbindung zwischen der Aluminium enthaltenden Schicht und der Germanium enthaltenden Schicht ist es vorteilhaft, wenn die Schichtdicke der Aluminium enthaltenden Schicht und/oder der Germanium enthaltenden Schicht mindestens etwa 50 Nanometer beträgt. Besonders bevorzugt ist jedoch eine Ausführungsform bei der die Dicke aus einem Wertebereich zwischen etwa 50 Nanometern und etwa 5000 Nanometern, vorzugsweise aus einem Wertebereich zwischen etwa 100 Nanometern und etwa 2000 Nanometern, gewählt wird. Besonders bevorzugt ist eine Dicke zumindest einer der Schichten von etwa 1500 Nanometern.

Von besonderem Vorteil ist eine Ausführungsform bei der den eutektisch miteinander verbundenen Schichten des Verbundes nicht eine ausschließliche Befestigungsfunktion zukommt, sondern bei der die eutektisch miteinander verbundenen, Aluminium bzw. Germanium enthaltenden Schichten als Kontaktierung zwischen den beiden Halbleitersubstraten ausgebildet sind. Dabei ist es realisierbar, dass über die gebildeten Kontaktpads Leiterbahnen oder elektronische Bauelemente elektrisch leitend miteinander verbunden werden.

Von besonderem Vorteil ist eine Ausführungsform bei der das MEMS-Bauelement oder die MEMS-Bauelemente und/oder, falls vorgesehen, das mindestens eine ASIC-Bauelement durch die eutektische Verbindung der mindestens einen, Aluminium enthaltenden Schicht und der mindestens einen, Germanium enthaltenden Schicht hermetisch gekapselt sind/ist. Dies kann beispielsweise dadurch realisiert werden, dass die Schichten in Form eines Bondrahmens, der das mindestens eine MEMS-Bauelement und/oder das mindestens eine ASIC-Bauelement vollumfänglich umschließt, ausgebildet sind.

Erfindungsgemäß ist eine Ausführungsform, bei der die mindestens eine Germanium enthaltende Schicht um mindestens um den Faktor 10, dünner ist, als die mindestens eine Aluminium enthaltende Schicht. Bei einer derartigen Ausführungsform wird nur ein Teil der Aluminium enthaltenden Schicht für die Ausbildung des Al/Ge-Eutektikums verbraucht. Dies hat den entscheidenden Vorteil, dass das verbleibende Aluminium als Abstandshalter (sogenannte Spacer-Schicht) zwischen den beiden zu verbindenden Halbleitersubstraten (Wafern) dient. Dies kann insbesondere für bewegliche MEMS- Inertialsensoren vorteilhaft sein, um zu verhindern, dass die Sensor-Strukturen an das angebondete Halbleitersubstrat anschlagen können. Bevorzugt ist eine Ausführungsform, bei der die Aluminium enthaltende Schicht in einer Dicke zwischen etwa 2 µm und etwa 10 µm realisiert ist. Bevorzugt beträgt die Dicke der Germanium enthaltenden Schicht nur etwa 100 bis etwa 700 Nanometer. Hieraus ergibt sich bevorzugt eine eutektische Zone (eutektische Schicht) mit einer Schichtdicke von etwa 1 µm.

Die Erfindung führt auch auf ein Verfahren zum Herstellen eines Verbundes aus einem ersten, mindestens ein MEMS-Bauelement aufweisenden Halbleitersubstrates und mindestens einem zweiten Halbleitersubstrat, wobei das zweite Halbleitersubstrat bevorzugt mindestens ein ASIC-Bauelement trägt. Besonders bevorzugt dient das Verfahren zum Herstellen eines vorgeschriebenen Verbundes. Bei dem Verfahren wird durch Temperatureinwirkung mit einer Temperatur, die vorzugsweise oberhalb der Liquidustemperatur des Eutektikums liegt, und ggf. durch zusätzliche Druckeinwirkung eine eutektische Verbindung zwischen einer Aluminium enthaltenden Schicht und einer Germanium enthaltenden Schicht nach dem Zusammenführen der Halbleitersubstrate vorzugsweise nach einem vorherigen Ausrichtvorgang (Alignment) geschaffen. Kerngedanke eines nach dem Konzept der Erfindung ausgebildeten Verfahrens ist es dabei, dass die mindestens eine Aluminium enthaltende Schicht auf das erste Halbleitersubstrat und die mindestens eine Germanium enthaltende Schicht auf das zweite Halbleitersubstrat aufgebracht werden.

Besonders bevorzugt ist eine Ausführungsform des Verfahrens, bei der die mindestens eine Germanium enthaltende Schicht als letzter Verfahrensschritt bei der Herstellung des zweiten, ein ASIC-Bauelement aufweisenden Halbleitersubstrates aufgebracht wird. Hierdurch kann eine Passivierung des Germaniums bei der Herstellung des Halbleitersubstrates bzw. des ASIC-Bauelementes unterbleiben.

In Weiterbildung der Erfindung ist mit Vorteil vorgesehen, dass die Aluminium enthaltende Schicht und/oder die Germanium enthaltende Schicht durch einen Depositprozess, vorzugsweise durch Sputtern oder CVD-Beschichten, vorzugsweise durch PE-CVD-Beschichten, auf das entsprechende Halbleitersubstrat aufgebracht werden/wird.

Zum Herstellen einer festen, eutektischen Verbindung ist es vorteilhaft, die Aluminium enthaltende Schicht und/oder die Germanium enthaltende Schicht strukturiert auf das entsprechende Halbleitersubstrat aufzubringen und/oder nach dem Aufbringen zu strukturieren, insbesondere zu mikrostrukturieren.

### Kurze Beschreibung der Zeichnungen

Weitere Vorteile, Merkmale und Einzelheiten der Erfindung ergeben sich der nachfolgenden Beschreibung bevorzugter Ausführungsbeispiele sowie anhand der Zeichnungen. Diese zeigen in:
- Fig. 1: in einer Schnittansicht ein erstes Halbleitersub- strat mit MEMS-Bauelementen (Sensorstruktur) vor dem Fügen mit einem zweiten Halbleitersubstrat,
- Fig. 2: in einer Schnittansicht das zweite Halbleitersub- strat mit ASIC-Bauelementen vor dem Fügen mit dem in Fig. 1 gezeigten ersten Halbleitersubstrat und
- Fig. 3: in einer Schnittansicht einen Verbund aus den in den Fig. 1 und 2 gezeigten Halbleitersubstraten.

### Ausführungsformen der Erfindung

In den Figuren sind gleiche Bauteile und Bauteile mit der gleichen Funktion mit den gleichen Bezugszeichen gekennzeichnet.

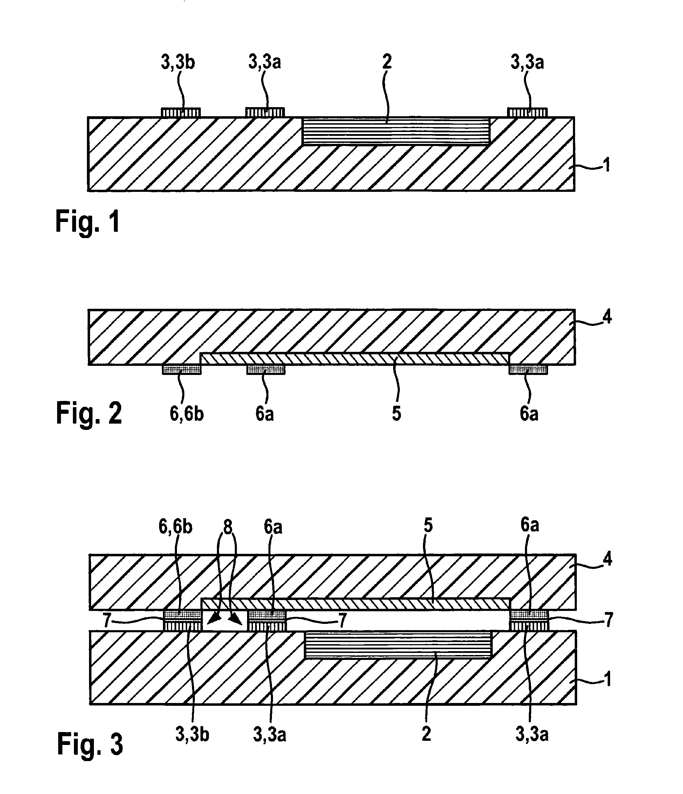

In Fig. 1 ist ein erstes Halbleitersubstrat 1 (MEMS-Wafer) gezeigt. Auf das erste Halbleitersubstrat 1 wurden MEMS-Bauelemente 2 (hier: Sensorstruktur) durch Opferschichtätzen aufgebracht. Ferner wurde in mehreren Regionen eine Aluminium enthaltende Schicht 3 zum Herstellen einer später noch zu erläuternden eutektischen Verbindung auf das erste Halbleitersubstrat 1 abgeschieden. Bei der mit dem Bezugszeichen 3a gekennzeichneten, Aluminium enthaltenden Schicht, handelt es sich um einen die MEMS-Bauelemente 2 umschließenden Bondrahmen. Bei der mit den Bezugszeichen 3b gekennzeichneten, Aluminium enthaltenden Schicht handelt es sich um einen Kontakt-Pad zum Herstellen einer elektrischen Verbindung zu dem in Fig. 2 gezeigten, zweiten Halbleitersubstrat 4. Das zweite Halbleitersubstrat 4 (ASIC-Wafer) weist auf seiner in der Zeichnungsebene unteren Seite ASIC-Bauelemente 5 (Prozessor) sowie in mehreren Regionen eine Germanium enthaltende Schicht 6 auf. Dabei ist die mit dem Bezugszeichen 6a gekennzeichnete, Germanium enthaltende Schicht als umfangsgeschlossener Bondrahmen ausgebildet, der in seinen Abmessungen mit dem Bondrahmen 3a auf dem ersten Halbleitersubstrat 1 korrespondiert. Die mit dem Bezugszeichen 6b gekennzeichnete, Germanium enthaltende Schicht ist als Kontaktpad ausgebildet und korrespondiert mit dem mit dem Bezugszeichen 3b gekennzeichneten Kontakt-Pad auf dem ersten Halbleitersubstrat.

Nach dem relativen Ausrichten (Alignment) zueinander werden die Halbleitersubstrate 1, 4, wie in Fig. 3 dargestellt, zusammengeführt, wobei nach dem Zusammenführen ein Erhitzen der Schichten 3, 6, beispielsweise in einem Lötofen mindestens auf Liquidustemperatur erfolgt. Ggf. werden die Halbleitersubstrate 1, 4 dabei zusätzlich mit Druck (Anpressdruck) beaufschlagt. Dabei bildet sich zwischen den Aluminium enthaltenden Schichten 3 und den Germanium enthaltenden Schichten 6 jeweils eine Eutektikumsschicht 7 aus. Diese sorgt für eine feste Verbindung der beiden Halbleitersubstrate 1, 4 und für eine hermetische Kapselung der MEMS-Bauelemente 2. Neben dem aus den Kontaktpads 3b, 6b gebildeten Kontakt 8 kann auch mindestens ein innerhalb des Bondrahmens 3a angeordneter elektrischer Kontakt zwischen den Halbleitersubstraten 1, 4 vorgesehen werden. Ebenso können außerhalb des Bondrahmens weitere elektrische Kontakte vorgesehen werden. Weiterhin ist es denkbar im bzw. am ersten Halbleitersubstrat 1 und/oder am zweiten Halbleitersubstrat 4 Durchkontakte für die MEMS-Bauelemente 2 bzw. die ASIC-Bauelemente 5 vorzusehen.

In dem gezeigten Ausführungsbeispiel beträgt die Schichtdicke der Aluminium enthaltenden Schichten 3 etwa 1,5 µm. Ebenso beträgt die Schichtdicke der Germanium enthaltenden Schichten jeweils etwa 1,5 µm. Es sind auch geringere Schichtdicken realisierbar. Zusätzlich oder alternativ zu dem Aufdrucken der Aluminium enthaltenden Schichten 3 und/oder der Germanium enthaltenden Schichten 6 ist ein Abscheiden durch Sputtern oder CVD-Beschichten realisierbar.

## Patentansprüche

1. Verbund aus einem ersten, mindestens ein MEMS-Bauelement (2) aufweisenden Halbleitersubstrat (1) und mindestens einem zweiten Halbleitersubstrat (4), wobei mindestens eine, Germanium enthaltende Schicht (6) eutektisch mit mindestens einer, Aluminium enthaltenden Schicht (3)verbunden ist, wobei die Aluminium enthaltende Schicht (3) auf dem ersten Halbleitersubstrat (1) und die Germanium enthaltende Schicht (6) auf dem zweiten Halbleitersubstrat (4) vorgesehen ist, **dadurch gekennzeichnet, dass** die Germanium enthaltende Schicht (6) um mindestens den Faktor 10 dünner ist als die Aluminium enthaltende Schicht (3).

2. Verbund nach Anspruch 1,
**dadurch gekennzeichnet,**
**dass** das zweite Halbleitersubstrat (4) mindestens ein ASIC-Bauelement (5) aufweist.

3. Verbund nach einem der Ansprüche 1 oder 2,
**dadurch gekennzeichnet,**
**dass** die Aluminium enthaltende Schicht (3) und/oder die Germanium enthaltende Schicht (6) strukturiert, vorzugsweise mikrostrukturiert, ist.

4. Verbund nach einem der vorhergehenden Ansprüche, **dadurch gekennzeichnet**
**dass** die Aluminium enthaltende Schicht (3) aus Aluminium und/oder AlSiCu und/oder AlSi und/oder ALCu gebildet ist.

5. Verbund nach einem der vorhergehenden Ansprüche, **dadurch gekennzeichnet,**
**dass** die Aluminium enthaltende Schicht (3) und/oder die Germanium enthaltende Schicht (6), insbesondere vor dem eutektischen Verbinden, eine Dicke aus einem Wertebereich zwischen etwa 50 nm und etwa 5000 nm, vorzugsweise aus einem Wertebereich zwischen etwa 100 nm und etwa 2000 nm aufweist.

6. Verbund nach einem der vorhergehenden Ansprüche, **dadurch gekennzeichnet,**
**dass** die eutektisch miteinander verbundenen Schichten als elektrischer Kontakt (8) ausgebildet sind.

7. Verbund nach einem der vorhergehenden Ansprüche, **dadurch gekennzeichnet,**
**dass** das MEMS-Bauelement (2) und/oder das ASIC-Bauelement (5) durch die eutektische Verbindung hermetisch gekapselt sind/ist.

8. Verfahren zum Herstellen eines Verbundes (1) aus einem ersten, mindestens ein MEMS-Bauelement (2) aufweisenden Halbleitersubstrates (1) und mindestens einem zweiten Halbleitersubstrat (4), insbesondere eines Verbundes (1) nach einem der vorhergehenden Ansprüchen, wobei eine eutektische Verbindung zwischen einer Aluminium enthaltenden Schicht (3) und einer Germanium enthaltenden Schicht (6) durch Zusammenführen der Halbleitersubstrate (1, 4), Erhitzen der Schichten und vorzugsweise Aufbringen eines Anpressdrucks geschaffen wird, dass auf das erste Halbleitersubstrat (1) die Aluminium enthaltende Schicht (3) und auf das zweite Halbleitersubstrat (4) die Germanium enthaltende Schicht (6) so aufgebracht werden, dass die Germanium enthaltende Schicht (6) um mindestens den Faktor 10 dünner ist als die Aluminium enthaltende Schicht (3).

9. Verfahren nach Anspruch 8,
**dadurch gekennzeichnet,**
**dass** die Germanium enthaltende Schicht (6) als letzter Verfahrenschritt bei der Herstellung des zweiten, mindestens ein ASIC-Bauelement (5) aufweisenden Halbleitersubstrates (4) aufgebracht wird.

10. Verfahren nach einem der Ansprüche 8 oder 9,
**dadurch gekennzeichnet,**
**dass** die Aluminium enthaltende Schicht (3) und/oder die Germanium enthaltende Schicht (6) durch einen Depositprozess, vorzugsweise durch Sputtern oder CVD-Beschichten, aufgebracht werden/wird.

11. Verfahren nach einem der Ansprüche 8 bis 10,
**dadurch gekennzeichnet,**
**dass** die Aluminium enthaltende Schicht (3) und/oder die Germanium enthaltende Schicht (6) strukturiert aufgebracht werden/wird und/oder nach dem Aufbringen strukturiert, insbesondere mikrostrukturiert, werden/wird.

## Claims

1. Composite comprising a first semiconductor substrate (1), having at least one MEMS component (2), and at least a second semiconductor substrate (4), at least one germanium-containing layer (6) being eutectically bonded to at least one aluminium-containing layer (3), the aluminium-containing layer (3) being provided on the first semiconductor substrate (1) and the germanium-containing layer (6) being provided on the second semiconductor substrate (4), **characterized in that** the germanium-containing layer (6) is thinner than the aluminium-containing layer (3) by at least a factor of 10.

2. Composite according to Claim 1, **characterized in that** the second semiconductor substrate (4) has at least one ASIC component (5).

3. Composite according to either of Claims 1 and 2, **characterized in that** the aluminium-containing layer (3) and/or the germanium-containing layer (6) is structured, preferably microstructured.

4. Composite according to one of the preceding claims, **characterized in that** the aluminium-containing layer (3) is formed from aluminium and/or AlSiCu and/or AlSi and/or AlCu.

5. Composite according to one of the preceding claims, **characterized in that**, in particular before the eutectic bonding, the aluminium-containing layer (3) and/or the germanium-containing layer (6) has/have a thickness from a range of values between approximately 50 nm and approximately 5000 nm, preferably from a range of values between approximately 100 nm and approximately 2000 nm.

6. Composite according to one of the preceding claims, **characterized in that** the layers eutectically bonded to each other are formed as an electrical contact (8).

7. Composite according to one of the preceding claims, **characterized in that** the MEMS component (2) and/or the ASIC component (5) is/are hermetically encapsulated by the eutectic bonding.

8. Method for producing a composite (1) comprising a first semiconductor substrate (1), having at least one MEMS component (2), and at least a second semiconductor substrate (4), in particular a composite (1) according to one of the preceding claims, a eutectic bond being created between an aluminium-containing layer (3) and a germanium-containing layer (6) by bringing the semiconductor substrates (1, 4) together, heating the layers and preferably applying a contact pressure, in that the aluminium-containing layer (3) is applied to the first semiconductor substrate (1) and the germanium-containing layer (6) is applied to the second semiconductor substrate (4) in such a way that the germanium-containing layer (6) is thinner than the aluminium-containing layer (3) by at least a factor of 10.

9. Method according to Claim 8, **characterized in that** the germanium-containing layer (6) is applied as the last method step in the production of the second semiconductor substrate (4), having at least one ASIC component (3).

10. Method according to either of Claims 8 and 9, **characterized in that** the aluminium-containing layer (3) and/or the germanium-containing layer (6) is/are applied by a depositing process, preferably by sputtering or CVD coating.

11. Method according to one of Claims 8 to 10, **characterized in that** the aluminium-containing layer (3) and/or the germanium-containing layer (6) is/are applied in a structured form and/or is/are structured, in particular microstructured, after being applied.

## Revendications

1. Ensemble constitué d'un premier substrat semi-conducteur (1) qui présente au moins un composant MEMS (2) et d'au moins un deuxième substrat semi-conducteur (4),
au moins une couche (6) qui contient du germanium étant reliée eutectiquement à au moins une couche (3) qui contient de l'aluminium,
la couche (3) qui contient de l'aluminium étant prévue sur le premier substrat semi-conducteur (1) et la couche (6) qui contient du germanium sur le deuxième substrat semi-conducteur (4),
**caractérisé en ce que**
la couche (6) qui contient du germanium est plus mince que la couche (3) qui contient de l'aluminium d'un facteur d'au moins 10.

2. Ensemble selon la revendication 1, **caractérisé en ce que** le deuxième substrat semi-conducteur (4) présente au moins un composant ASIC (5).

3. Ensemble selon l'une des revendications 1 ou 2, **caractérisé en ce que** la couche (3) qui contient de l'aluminium et/ou la couche (6) qui contient du germanium sont structurées et de préférence micro-structurées.

4. Ensemble selon l'une des revendications précédentes, **caractérisé en ce que** la couche (3) qui contient de l'aluminium est formée d'aluminium, d'AlSiCu, d'AlSi et/ou d'AlCu.

5. Ensemble selon l'une des revendications précédentes, **caractérisé en ce qu'**en particulier avant la liaison eutectique, l'épaisseur de la couche (3) qui contient de l'aluminium et/ou la couche (6) qui contient du germanium est comprise dans une plage de valeurs d'environ 50 nm à environ 5 000 nm et de préférence dans une plage de valeurs comprise entre environ 100 nm et environ 2 000 nm.

6. Ensemble selon l'une des revendications précédentes, **caractérisé en ce que** les couches reliées l'une à l'autre eutectiquement sont configurées comme contacts électriques (8).

7. Ensemble selon l'une des revendications précédentes, **caractérisé en ce que** le composant MEMS (2) et/ou le composant ASIC (5) sont encapsulés hermétiquement par la liaison eutectique.

8. Procédé de fabrication d'un ensemble (1) constitué d'un premier substrat semi-conducteur (1) qui présente au moins un composant MEMS (2) et d'au moins un deuxième substrat semi-conducteur (4), en particulier pour fabriquer un ensemble (1) selon l'une des revendications précédentes, dans lequel
une liaison eutectique entre une couche (3) qui contient de l'aluminium et une couche (6) qui contient du germanium est formée en assemblant les substrats semi-conducteurs (1, 4), en chauffant les couches et en appliquant de préférence une poussée,
la couche (3) qui contient de l'aluminium est appliquée sur le premier substrat semi-conducteur (1) et la couche (6) qui contient du germanium sur le deuxième substrat semi-conducteur (4) de telle sorte que la couche (6) qui contient du germanium soit plus mince que la couche (3) qui contient de l'aluminium d'un facteur d'au moins 10.

9. Procédé selon la revendication 8, **caractérisé en ce que** la couche (6) qui contient du germanium est appliquée en dernière étape du procédé lors de la fabrication du deuxième substrat semi-conducteur (4) qui présente au moins un composant ASIC (5).

10. Procédé selon l'une des revendications 8 ou 9, **caractérisé en ce que** la couche (3) qui contient de l'aluminium et/ou la couche (6) qui contient du germanium sont appliquées par une opération de dépôt et de préférence par pulvérisation ou revêtement par CVD.

11. Procédé selon l'une des revendications 8 à 10, **caractérisé en ce que** la couche (3) qui contient de l'aluminium et/ou la couche (6) qui contient du germanium sont appliquées après avoir été structurées et/ou sont structurées et en particulier micro-structurées après avoir été appliquées.
